# FASCICULE DE BREVET EUROPEEN

(11) **EP 0 323 295 B1**
(45) Date de publication et mention de la délivrance du brevet: **13.01.1993**
(21) Numéro de dépôt: 88403141.0
(22) Date de dépôt: 09.12.1988
(51) Int. Cl.: G06K 19/06, H01L 23/50

(54) **Procédé pour fixer sur un support un composant électronique et ses contacts**
Verfahren zum Befestigen eines elektronischen Bausteins und seiner Kontakte auf einen Träger
Method for fixing an electronic component and its contacts on a carrier

(30) Priorité: 22.12.1987 FR 8717900
(43) Date de publication de la demande: 05.07.1989
(73) Titulaire: SGS-THOMSON MICROELECTRONICS S.A., 94250 Gentilly (FR)
(72) Inventeur: Gloton, Jean-Pierre, F-75116 Paris (FR)
(74) Mandataire: Ballot, Paul Denis Jacques

(56) Documents cités:
- EP-A- 0 029 785
- EP-A- 0 207 853
- EP-A- 0 246 744
- EP-A- 0 246 973
- FR-A- 2 483 128
- GB-A- 2 088 630

## Description

L'invention concerne un procédé pour mettre en place et fixer, sur un support tel qu'une carte d'identification ou une carte bancaire présentant une cavité, un composant électronique et ses contacts de manière que le composant électronique soit logé dans la cavité et que ses contacts soient fixés sur la carte.

Il est courant d'utiliser des cartes d'identification dans de nombreux domaines, notamment dans celui des cartes bancaires ou de crédit. Pendant très longtemps, ces cartes ne comportèrent, outre un numéro d'identification et le nom du titulaire, qu'un enregistrement magnétique qui en permettait l'identification par lecture magnétique. Depuis quelques années, ces cartes sont utilisées à d'autres fonctions que l'identification du titulaire et, en particulier, à des fins de pré-paiement et de protection contre les actions des fraudeurs. A cet effet, la carte comporte un composant électronique actif qui peut être constitué d'une mémoire électronique associée ou non à un microprocesseur, ce qui permet de l'utiliser notamment pour des applications de type bancaire.

Les cartes de crédit de cette technique, qui comportent un composant électronique, sont fabriquées de diverses manières. Selon un premier procédé, une cavité est aménagée dans l'épaisseur de la carte pour recevoir le composant électronique. Selon un autre procédé, dit de "co-laminage", on lamine de fines couches de matière plastique : polyépoxy, polyéthylène, polychlorure de vinyl etc... autour du composant. Lors de la mise en oeuvre de ces procédés, diverses opérations sont en outre effectuées pour assurer la connexion électrique des bornes du composant électronique à des métallisations qui sont disposées en surface sur la carte.

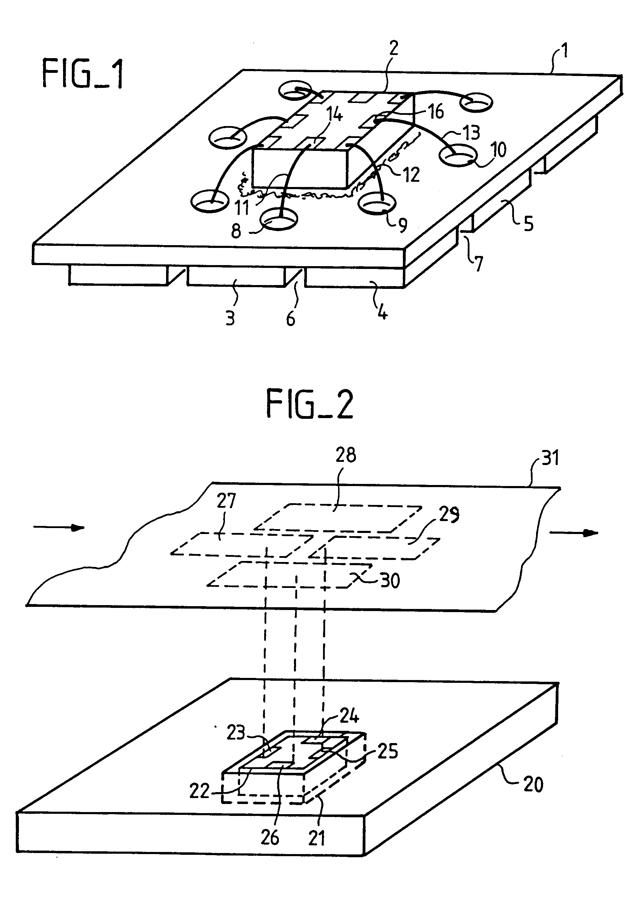

L'un des procédés pour mettre en place le composant électronique dans la cavité aménagée dans la carte et pour disposer les métallisations sur la carte ainsi que pour réaliser les connexions entre les bornes de la carte et les métallisations, consiste, comme le montre la figure 1, à utiliser un film 1 non conducteur, par exemple en polyépoxy, qui porte d'un côté le composant électronique sous forme d'une "puce" (référence 2) et de l'autre côté des surfaces métallisées, telles que celles référencées 3, 4 et 5, et séparées les unes des autres par des espaces 6 et 7 sans métallisation. Ces surfaces métallisées 3, 4 et 5 communiquent avec l'autre côté du film 1 par des trous 8, 9 et 10 par l'intermédiaire desquels les extrémités des fils conducteurs 11, 12 et 13 viennent se connecter aux surfaces métallisées correspondantes par tout moyen connu, tel qu'une colle conductrice. L'autre extrémité de chaque fil conducteur est connectée à une borne de sortie 14, 15 ou 16 de la puce 2.

Ces opérations sont ensuite suivies de l'enrobage de la puce 2 avec de la résine et d'une cuisson de la résine pour obtenir l'encapsulation de la puce. On peut alors mettre en place la puce dans la cavité de la carte et disposer les métallisations sur les bords de la cavité par simple emboîtage de la puce et collage du film support 1 sur la carte après son découpage aux dimensions requises.

Selon un tel procédé, les contacts électriques et la puce, ou composant électronique, sont d'abord mis en place sur le film soit d'un côté du film, soit dans l'épaisseur du film, puis le raccordement électrique est réalisé entre les bornes de sortie de la puce et les contacts électriques préalablement déposés sur le film. Après encapsulation, l'ensemble est mis en place sur la carte par collage de la puce encapsulée dans le fond de la cavité prévue à cet effet, tandis que le film est collé sur les bords de la cavité de manière que les contacts électriques soient accessibles à l'extérieur de la carte.

Un tel procédé est par exemple décrit dans les brevets EP-A-0 207 853 et FR-A-2 483 128.

Ce procédé présente l'inconvénient de nécessiter de nombreuses manipulations, notamment pour obtenir que la puce soit portée par le film-support, puis connectée aux contacts électriques, ensuite encapsulée et enfin mise en place dans la cavité. En outre, l'opération d'encapsulation est très longue, car il n'est pas possible de chauffer la résine au-delà de 150°C : le film et la colle des contacts ne supporteraient pas une température supérieure.

Le but de la présente invention est donc de mettre en oeuvre un procédé qui, destiné à fixer sur un support tel qu'une carte d'identification un composant électronique et ses contacts, ne présente pas les inconvénients des procédés de l'art antérieur.

L'invention se rapporte donc à un procédé selon la revendication 1 pour fixer sur un support un composant électronique et ses contacts, ledit support comportant une cavité pour loger ledit composant, caractérisé en ce qu'il comprend les opérations suivantes :
a) la mise en place d'un composant électronique dans la cavité de manière que les bornes de sortie du composant soient accessibles par l'ouverture de la cavité ;
b) la mise en place des contacts électriques sur un film de support, selon un motif approprié à la géométrie des bornes de sortie du composant électronique ;
c) la mise en place des contacts électriques sur le support ;
d) le raccordement électrique simultané desdits contacts électriques aux bornes de sortie du composant électronique, les opérations c) et d) étant réalisées par un procédé de transfert à chaud.

D'autres caractéristiques et avantages de la présente invention apparaîtront à la lecture de la description suivante d'un exemple particulier de réalisation, ladite description étant faite en relation avec le dossier joint dans lequel :
- la figure 1 est une vue en perspective cavalière d'un composant électronique et de ses connexions disposés sur un film support selon l'art antérieur ;
- la figure 2 est une vue en perspective cavalière montrant le composant électronique sur le support avant son raccordement électrique, selon l'invention, avec les contacts électriques extérieurs ;
- la figure 3 est une vue en perspective cavalière d'un autre arrangement de support des contacts utilisable selon le procédé de l'invention.

La figure 1, qui correspond à un procédé de l'art antérieur, a été décrite dans le préambule. Selon ce procédé, il y a d'abord une préparation de l'ensemble -composant électronique-contacts électriques- sur un support séparé, puis assemblage de cet ensemble sur la carte. L'invention repose sur une approche entièrement différente de manière à éviter, d'une part, l'opération de raccordement électrique de la puce sur les contacts électriques du film de support et, d'autre part, l'opération d'encapsulation une fois que la puce est sur le film de support.

Ce nouveau procédé consiste d'abord à fixer la puce, ençapsulée ou non, dans la cavité de la carte, de manière que ses bornes de sortie affleurent au niveau de l'ouverture de la cavité. Cette opération est suivie d'un collage des contacts sur la carte et, simultanément, de leur raccordement électrique aux bornes de sortie de la puce.

Sur la figure 2, on a représenté la carte 20 qui comporte une cavité 21 dont la partie inférieure est fermée par le fond de la carte tandis que la partie supérieure est ouverte pour permettre la mise en place d'un composant électronique, sous la forme d'une puce 22. Cette puce 22 est essentiellement constituée d'un socle en silicium dans et sur lequel on a réalisé, sous forme de circuits intégrés, un circuit électronique complexe. Ce dernier présente des bornes de sortie 23 à 26 qui ont été disposées de manière à apparaître du côté ouverture de la cavité. Habituellement, pour protéger la puce et les bornes de sortie, l'ensemble est enrobé dans une épaisseur de résine qui laisse dépasser les bornes de sortie. Cette résine est durcie par chauffage à une température de 300°C environ. La puce 22 est logée dans la cavité 21 et collée sur le fond par tout procédé connu qui permette un positionnement précis par rapport à la carte, de manière que les bornes de sortie 23 à 26 aient des positions précises dans l'espace, par exemple une précision de l'ordre de cent microns. Il s'agit là d'une opération purement mécanique qui ne présente aucune difficulté dans l'état actuel de la technique.

Lorsque la puce 22 est en place dans la cavité, il est procédé à la mise en place des contacts sur la carte 20 et à leur raccordement électrique aux bornes de sortie 23 à 26. Pour cela, il est prévu de déposer des contacts 27 à 30 sur un film 28, selon un motif approprié. Les contacts 27 à 30 sont ensuite transférés du film 31 sur la carte 20 par encollage, pressage et chauffage. Au cours de cette opération de transfert, dite à chaud, les contacts 27 à 30 viennent se souder, respectivement, sur les bornes de sortie 23 à 26. Par ailleurs, lorsque le pressage cesse et que l'on sépare la carte du film 31, ce dernier se détache des contacts 27 à 30 qui, eux, restent collés sur la carte 20.

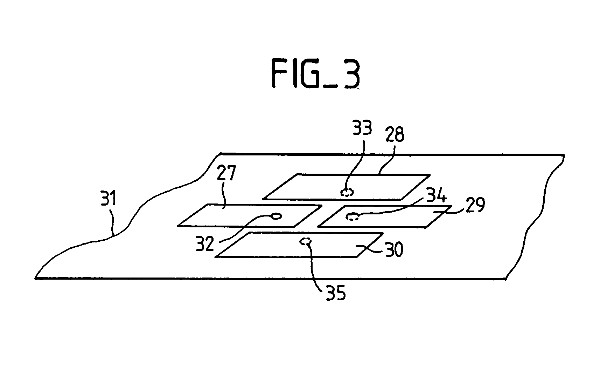

En variante du procédé, il est proposé (figure 3) de déposer sur la carte 20, non seulement les contacts 27 à 30, mais aussi une partie découpée du film 31. Selon cette variante, les contacts 27 à 30 sont déposés sur la face supérieure du film 31 et non pas sur la face inférieure, comme le montre la figure 2. Pour que le raccordement électrique avec les bornes de sortie 23 à 26 puisse s'effectuer, chaque contact 27 à 30 communique avec la face inférieure du film par un orifice 32 à 35 qui est convenablement placé par rapport à la position de la borne de sortie associée. Le film, ou plus exactement la partie du film qui porte les contacts 27 à 30, est ensuite collé sur la carte 20 tandis que les bornes de sortie 23 à 26 sont soudées, respectivement, aux contacts 27 à 30 par l'intermédiaire de l'orifice correspondant 32 à 35.

Les contacts 27 à 30 peuvent avoir des formes diverses, formes qui varient en fonction de la géométrie et de la disposition des bornes de sortie 23 à 26 de la puce.

Par ailleurs, le point de raccordement entre le contact et la borne de sortie peut aussi avoir des formes diverses. Ce peut-être un raccordement entre deux surfaces, comme c'est le cas sur la figure 2, ou un raccordement entre un point et une surface, ou encore entre deux points, comme c'est le cas sur la figure 3. On peut aussi avoir un raccordement fil à fil, si les contacts 27 à 30 sont prolongés par des conducteurs de faible largeur dont les extrémités sont soudées aux bornes de sortie du composant électronique.

## Revendications

1. Procédé pour fixer sur un support (20) un composant électronique (22) et ses contacts(27 à 30), ledit support (20) comportant une cavité (21) pour loger ledit composant (22), caractérisé en ce qu'il comprend les opérations suivantes :
a) la mise en place d'un composant électronique (22) dans la cavité (21) de manière que les bornes de sortie (23 à 26) du composant (22) soient accessibles par l'ouverture de la cavité ;
b) la mise en place des contacts électriques (27 à 30) sur un film de support (31), selon un motif approprié à la géométrie des bornes de sortie du composant électronique ;
c) la mise en place des contacts électriques (27 à 30) sur le support (20), à l'aide du film de support (31);
d) le raccordement électrique simultané desdits contacts électriques (27 à 30) aux bornes de sortie (23 à 26) du composant électronique (22), les opérations c) et d) étant réalisées par un procédé de transfert à chaud.

2. Procédé selon la revendication 1, caractérisé en ce que les contacts électriques (27 à 30) sont disposés sur une face du film de support (31) faisant face à ladite cavité de manière à se détacher dudit film de support (31) et se coller sur le support (20) lors de l'opération de mise en place sur le support.

## Claims

1. A method of fixing an electronic component (22) and its contacts (27 to 30) to a carrier (20), the said carrier (20) having a cavity (21) for housing the said component (22), characterized by comprising the following steps:
a) placing an electronic component (22) in the cavity (21) so that the output terminals (23 to 26) of the component (22) are accessible through the opening of the cavity;
b) positioning the electrical contacts (27 to 30) on a supporting film (31) in a pattern conforming to the geometry of the output terminals of the electronic component;
c) positioning the electrical contacts (27 to 30) on the carrier (20) by means of the supporting film (31);
d) simultaneously electrically connecting the said electrical contacts (27 to 30) to the output terminals (23 to 26) of the electronic component (22), the operations c) and d) being performed by a hot transfer process.

2. A method according to claim 1, characterized in that the electrical contacts (27 to 30) are disposed on a surface of the supporting film (31) facing towards the said cavity so as to become detached from the said supporting film (31) and to become adhesively bonded to the carrier (20) during the step of positioning on the carrier.

## Patentansprüche

1. Verfahren zum Befestigen eines elektronischen Bausteins (22) und seiner Kontakte (27 bis 30) auf einem Träger (20), wobei dieser Träger (20) eine Ausnehmung (21) zum Aufnehmen des Bausteins aufweist, dadurch gekennzeichnet, daß es die folgenden Vorgänge enthält:
a) das Anbringen eines elektronischen Bausteins (22) in der Ausnehmung (21) in der Weise, daß die Ausgangsklemmen (23 bis 26) des Bausteins (22) durch die Öffnung der Ausnehmung zugänglich sind;
b) das Anbringen der elektrischen Kontakte (27 bis 30) auf einer Trägerfolie (31) gemäß einem der Geometrie der Ausgangsklemmen des elektronischen Bausteins entsprechenden Muster;
c) das Anbringen der elektrischen Kontakte (27 bis 30) auf dem Träger (20) mit Hilfe der Trägerfolie (31);
d) das gleichzeitige elektrische Anschließen dieser elektrischen Kontakte (27 bis 30) an die Ausgangsklemmen (23 bis 26) des elektrischen Bausteins (22), wobei die Vorgänge c) und d) mit Hilfe eines mit Wärme durchgeführten Übertragungsprozesses verwirklicht werden.

2. Verfahren nach Anspruch 1, dadurch gekennzeichnet, daß die elektrischen Kontakte (27 bis 30) auf einer Fläche der Trägerfolie (31) angebracht werden, die zu der Ausnehmung zeigt, so daß sie sich bei dem Vorgang der Anbringung auf dem Träger von der Trägerfolie (31) lösen und auf dem Träger (20) festkleben.
